# DEMANDE DE BREVET EUROPEEN

(11) **EP 1 933 373 A2**
(43) Date de publication de la demande: **18.06.2008**
(21) Numéro de dépôt: 07122702.9
(22) Date de dépôt: 10.12.2007
(51) Int. Cl.: H01L 21/28, C23C 16/34, H01L 21/285, H01L 29/423

(54) **Procédé de réalisation d'un dispositif à base de nanocristaux recouverts d'une couche de nitrure déposée par CVD**

(30) Priorité: 15.12.2006 FR 0655561
(71) Demandeur: COMMISSARIAT A L'ENERGIE ATOMIQUE, 75015 Paris (FR)
(72) Inventeur: Colonna, Jean-Philippe, 38000, GRENOBLE (FR)
(74) Mandataire: Poulin, Gérard

(57) **Abrégé**

L'invention concerne un procédé de réalisation d'une structure comprenant des nanocristaux de matériau semi-conducteur sur un substrat (13) de matériau diélectrique (12) par dépôt chimique en phase vapeur (CVD), les nanocristaux étant recouverts d'une couche de nitrure. Le procédé comprend une étape de formation de germes (14) stables sur le substrat par dépôt CVD à partir d'un premier gaz précurseur des germes ; une étape de croissance de nanocristaux (16A,16B) à partir des germes stables par dépôt CVD à partir d'un second gaz précurseur ; une étape de formation d'une couche de nitrure de matériau semi-conducteur (17) sur les nanocristaux. Le procédé est caractérisé en ce que l'étape de passivation est réalisée par dépôt CVD sélectif et stoechiométrique de nitrure de matériau semi-conducteur uniquement sur les nanocristaux à partir d'un mélange du second et d'un troisième gaz précurseurs choisi pour engendrer un dépôt sélectif et stoechiométrique du nitrure uniquement sur lesdits nanocristaux, les étapes de formation des germes, de formation des nanocristaux et de passivation étant réalisées au sein d'une seule et même enceinte.

L'invention concerne également la formation de cellules mémoire et de mémoires flash comprenant des nanocristaux réalisés selon le procédé de l'invention.

## Description

### DOMAINE TECHNIQUE

L'invention concerne un procédé de réalisation d'un dispositif comprenant des nanocristaux, de taille et de densité déterminées, recouverts d'une couche de nitrure déposée par CVD. Le procédé permet en particulier d'obtenir des cellules mémoires pour réaliser des mémoires Flash.

### ÉTAT DE LA TECHNIQUE ANTÉRIEURE

Les mémoires flash utilisent comme cellules de base des transistors à effet de champ. Ces transistors comportent une grille flottante située entre le canal et la grille de contrôle du transistor, ainsi qu'un diélectrique tunnel situé entre le canal du transistor et la grille flottante.

La grille flottante constitue l'élément de stockage de l'information. Dans la technologie MOS (Metal Oxide Semiconductor) actuelle, la grille flottante est réalisée en silicium polycristallin dopé n.

Le diélectrique tunnel est généralement un oxyde de silicium (SiO₂) thermique. C'est à travers cet oxyde que sont injectées les charges depuis le canal vers la grille flottante.

Ces dernières années, les capacités des mémoires flash n'ont pas cessé d'augmenter avec la réduction continuelle des cellules élémentaires liée à la miniaturisation des dispositifs. Cette course à la densité d'intégration ainsi qu'à la diminution des temps d'opérations ont permis de faire augmenter la densité des mémoires de 64 Mbits en 1997 à 512 Mbits actuellement pour les mémoires Flash NOR et 2 Gbits pour les mémoires Flash NAND actuellement mises en production par Samsung en technologie 90 nm. Des réalisations de prototypes de mémoire Flash NAND 8 Gbits en technologie 63 nm en utilisant la technique MLC (Multi-Level-Cell) ont été également présentées par Samsung fin 2004.

Cependant, plusieurs obstacles technologiques commencent à s'opposer à la poursuite de l'augmentation des capacités des mémoires flash et de leur miniaturisation. En effet la réduction des dimensions des mémoires Flash s'accompagne d'une réduction des épaisseurs des diélectriques, en particulier de l'oxyde de grille. D'après l'ITRS 2004, les épaisseurs d'oxyde tunnel seront en 2007 de 8-9 nm pour les NOR et de 6-7 nm pour les NAND. Malheureusement, la réduction de l'épaisseur de l'oxyde tunnel, en particulier en dessous de 8 nm, donne lieu à une augmentation des courants de fuite à travers celui-ci par effet tunnel direct ou par des défauts dans cet oxyde, provoqués par la répétition des stress d'écriture et d'effacement (phénomène appelé SILC pour « Strain Induced Leakage Current »). La rétention, c'est à dire l'intégrité de l'information stockée sur des périodes de dix ans, est alors affectée.

Un autre problème important est la diminution des tensions de fonctionnement pour réduire la consommation en énergie et pour se rapprocher des faibles tensions d'utilisation (1 à 2 Volts) des transistors CMOS (Complementary MOS) de logique.

Pour pallier à ces difficultés, de nouvelles architectures et de nouveaux matériaux sont aujourd'hui étudiés pour les mémoires Flash.

Une des solutions adoptée consiste à remplacer la grille flottante en silicium polycristallin par des sites de piégeage discrets dans les mémoires Flash. Un des intérêts d'une grille flottante à sites de piégeage discret est l'isolement électrique des sites de piégeage entre eux. Par conséquent, la présence d'un défaut dans l'oxyde tunnel, qui entraîne une décharge complète dans le cas d'un dispositif à grille flottante continue, n'affectera que la charge située au dessus du défaut. Cette structure diminue donc l'effet du SILC et permet de diminuer l'épaisseur du diélectrique tunnel en conservant de bonnes caractéristiques de rétention et d'endurance. Dans les mémoires à sites de piégeage discrets, il est aussi possible de coder deux bits (soit quatre états), grâce au caractère localisé de la charge stockée.

Un exemple de mémoires à sites de stockage discrets est constitué par les mémoires à nanocristaux de silicium. Dans les mémoires à nanocristaux de silicium, la charge est stockée dans des nanocristaux de silicium (de taille de quelques nanomètres à une dizaine de nanomètres), qui sont situés entre le diélectrique tunnel et le diélectrique de contrôle.

Comme nous l'avons vu précédemment, les mémoires à nanocristaux présentent une robustesse accrue aux défauts dans l'oxyde tunnel par rapport aux mémoires à grille flottante continue et permettent donc de réduire l'épaisseur de l'oxyde tunnel et par conséquent, de diminuer les tensions d'écriture et d'effacement ou les temps de programmation. L'épaisseur de l'oxyde tunnel peut alors être réduite jusqu'à 5 nanomètres, sans dégrader de manière critique les propriétés de rétention, même après un grand nombre de cycles d'écritures/effacements. Les phénomènes parasites tels que le couplage capacitif entre la grille flottante et le drain, et le couplage latéral entre grilles voisines, deux phénomènes pouvant entraîner une écriture parasite des cellules voisines, sont également réduits. De plus, de par le caractère discret de la grille flottante, on peut envisager le stockage de plusieurs bits au sein d'une même cellule.

Depuis leur première présentation en 1995 par la société IBM, les mémoires à nanocristaux de silicium ont bénéficié d'énormes développements. Récemment, l'entreprise Freescale a présenté une mémoire de 4 Mbits, réalisée en technologie 90 nm et fonctionnant avec des tensions de programmation n'excédant pas 6 volts.

Cependant, les mémoires à nanocristaux ont aussi leurs limitations.

En particulier, ces mémoires présentent un faible couplage capacitif entre la grille de contrôle et la grille flottante, ce qui demande alors de maintenir les tensions de programmation à un niveau élevé et qui diminue en partie les bénéfices liés à la réduction de l'oxyde tunnel.

Une autre limitation tient au fait que les décalages de tension de seuil obtenus avec ces dispositifs sont assez faibles, principalement à cause du faible taux de couverture de la surface active par les nanocristaux de silicium (entre 5x10¹¹ et 10¹² par cm² avec un procédé de dépôt LPCVD (« Low Pressure Chemical Vapor Deposition ») largement utilisé actuellement pour ces mémoires).

Un autre inconvénient est la dispersion de la taille et de la position des nanocristaux sur l'oxyde tunnel, ce qui entraîne une dispersion des caractéristiques de la mémoire. Néanmoins, une récente étude montrant une matrice de 1 Mbits, fabriquée par ST Microelectronics en collaboration avec le CEA-LETI (voir document **[1]**), a permis d'obtenir une densité de nanocristaux égale à 2x10¹² cm⁻² avec des dispositifs présentant une fenêtre de programmation de 3 Volts, ce qui est conforme aux exigences portant sur les mémoires Flash. De plus, cette étude montre, en utilisant un modèle quantifiant la dispersion en tension de seuil, que ces mémoires remplissent les exigences en performance pour l'intégration jusqu'au noeud technologique 65 nm pour les applications de type NAND et 35 nm pour les applications de type NOR.

Une des méthodes d'élaboration de nanocristaux est décrite dans le document **[2]**. Il s'agit d'un procédé CVD (Chemical Vapor Deposition) en deux étapes qui permet de dissocier l'étape de nucléation et l'étape de croissance des nanocristaux. Cette méthode permet de réduire la dispersion en taille des nanocristaux comparée à un procédé standard CVD en une seule étape. Cette méthode a notamment été utilisée pour mettre au point un taux de couverture maximum d'environ 30% (voir document **[1]**). La taille des nanocristaux obtenus est inférieure à 10 nm et leur densité est de 2x10¹² par cm². Cette densité correspond à la densité limite obtenue avant coalescence, la coalescence étant le point où les îlots, que constituent les nanocristaux, commencent à se rejoindre pour former une couche continue.

Une autre difficulté majeure posée par les dispositifs à nanocristaux réside dans leur intégration avec les autres étapes de la réalisation de mémoires type Flash. Le problème posé ici est celui de l'oxydation des nanocristaux de silicium lors des étapes ultérieures, potentiellement oxydantes, mais également leur oxydation à l'air ambiant. Pour empêcher cette oxydation, il convient de passiver les nanocristaux de silicium, c'est-à-dire de les protéger de tout oxydant pouvant diffuser jusqu'à leur interface silicium/diélectrique de contrôle.

On trouve dans la littérature diverses sortes de passivation.

Par exemple, la société Freescale utilise un recuit sous NO, ce qui consomme la couche extérieure des nanocristaux pour former un oxynitrure. La présence de nitrure constitue ensuite une barrière aux oxydations futures (voir le document **[3]**).

On peut également utiliser la nitruration plasma pour former une couche de nitrure de silicium à la surface des nanocristaux de silicium (voir le document **[4]**).

Le premier problème que posent ces deux techniques de passivation, le recuit sous NO et la nitruration plasma, est qu'elles consomment des nanocristaux de silicium lors de la formation de la couche de passivation. En effet, la couche de passivation n'est pas une couche déposée, mais une couche formée à partir du silicium provenant des nanocristaux mêmes. Par exemple, pour des nanocristaux de diamètre inférieur à 10 nm, une couche passive de 2 nm et un « coeur » silicium de 6 nm (pour des nanocristaux de diamètre total 10 nm), la couche de passivation représente 40% d'un nanocristal, ce qui constitue une importante réduction des nanocristaux « utiles » en terme de stockage (c'est-à-dire la partie restante de silicium).

Le second problème que posent ces deux techniques de passivation concerne le diélectrique tunnel, ou plus spécifiquement l'oxyde tunnel. En effet, lors de la passivation, on risque de venir nitrurer l'oxyde tunnel, ce qui ne constitue pas forcément un problème, mais on doit toutefois veiller à ne pas dégrader les propriétés électriques de cet oxyde tunnel.

Un troisième problème est la formation d'un oxyde natif à la surface des nanocristaux. En effet, on peut considérer qu'un oxyde natif va se former à la surface des nanocristaux si ceux-ci sont exposés à l'atmosphère, après leur dépôt et avant la formation de la couche de passivation. Cet oxyde s'ajoutera donc à la couche de passivation.

Dans le cas du recuit sous NO, on forme un oxynitrure ayant une concentration en azote d'autant plus élevée que l'on se rapproche de l'interface Si/SiOx. Or c'est cette interface riche en azote qui protège les nanocristaux de silicium en constituant une véritable barrière à l'oxydation. En effet, la forte concentration en azote permet la formation de nombreuses liaisons Si-N qui retardent la diffusion des espèces oxydantes. On comprend donc que la partie externe de la couche de passivation, que l'on peut désigner comme étant du SiOx avec une faible concentration en azote, consomme le silicium des nanocristaux sans pour autant constituer une barrière à l'oxydation. Ainsi, seule l'interface Si/SiOx riche en azote constitue la partie utile de la couche de passivation, le reste de la couche consommant du silicium des nanocristaux en pure perte. Par conséquent, cette méthode de passivation par recuit sous NO ne peut s'appliquer que sur des nanocristaux de fort diamètre. Une image EFTEM dans le document [3] donne les dimensions suivantes : la couche de passivation NO représente 3 nm et le coeur silicium a un diamètre de 11,5 nm, ce qui correspond à un nanocristal de 17,5 nm (3x2 + 11,5). Or, selon le document **[1]**, des nanocristaux de cette dimension ne permettent pas en pratique d'obtenir des taux de recouvrement suffisant pour obtenir un décalage de tension de seuil satisfaisant avec une faible dispersion.

Un autre effet important du recuit sous NO est la nitruration de l'oxyde tunnel. Celle-ci dépend de l'épaisseur de l'oxyde tunnel et du budget thermique du recuit. Le mécanisme est le même que pour la nitruration des nanocristaux : diffusion à travers l'oxyde et dissociation de la molécule NO à l'interface Si/SiO₂. Un oxyde tunnel fin et un budget thermique important lors du recuit NO entraînent donc une nitruration de l'interface Si/oxyde tunnel. Celle-ci ne constitue pas forcément un problème dans la mesure où l'oxyde n'est pas dégradé, mais les propriétés électriques de l'oxyde tunnel s'en trouvent modifiées.

Dans le cas de la nitruration plasma, le document **[4]** donne les conditions suivantes : utilisation d'un plasma azote (RF=13,56 et Puissance=2,6 W/cm³) pendant 20 minutes à 800°C, ce qui entraîne la formation d'un nitrure de silicium d'1 nm d'épaisseur à la surface des nanocristaux. Pour évaluer la consommation de silicium des nanocristaux, il faut savoir s'il y a formation d'un oxyde natif ou non à la surface des nanocristaux, ou en d'autres termes, si les nanocristaux ont été exposés à l'atmosphère avant leur nitruration. En effet, un oxyde natif consommerait approximativement 0,5 nm de silicium sur le rayon d'un nanocristal, soit 1 nm sur le diamètre, auquel il faut ajouter aux 1 nm de nitrure. On a donc au total 2 nm de silicium consommé sur un nanocristal de 8 nm de diamètre. Dans l'hypothèse où il y aurait formation d'un oxyde natif à la surface des nanocristaux, on estime que l'oxyde natif exposé à un plasma azote dans les conditions décrites dans le document **[4]** serait entièrement gravé avant que le plasma ne vienne nitrurer les nanocristaux de silicium. Ceci est un point positif pour la passivation des nanocristaux, mais pose un réel problème pour l'oxyde tunnel. En effet, on pense que le traitement sous plasma azote dégrade la fiabilité de l'oxyde tunnel. De plus, les conditions opératoires nécessaires pour la nitruration plasma (c'est-à-dire 20 minutes à 800°C dans un équipement monoplaque) ne sont pas des conditions facilement mises en oeuvre dans un procédé à but « industriel ».

Au vu des inconvénients exposés ci-dessus, le but de l'invention est d'obtenir un procédé qui permette de réaliser des dispositifs à nanocristaux passivés, et en particulier des mémoires flash à nanocristaux de silicium présentant les caractéristiques suivantes :
- les nanocristaux ont une taille et une densité telles que le taux de couverture sur le diélectrique est maximum ;
- la passivation est réalisée sans que les nanocristaux soient exposés à une atmosphère oxydante ;
- la passivation constitue une barrière efficace contre l'oxydation (la passivation doit assurer une bonne résistance aux procédés ultérieurs oxydants) ;
- la passivation ne consomme pas les nanocristaux, de manière à conserver la taille initiale des nanocristaux et ainsi, un taux de couverture maximal ;
- la couche de passivation ne dégrade pas les matériaux existant tels que le diélectrique tunnel.

### EXPOSÉ DE L'INVENTION

Ce but est atteint par un procédé CVD (« Chemical Vapor Deposition ») comprenant à la fois l'élaboration de nanocristaux de taille et de densité déterminées et leur passivation, sous forme de dépôt de nitrure stoechiométrique uniquement localisé sur les nanocristaux. On peut ainsi réaliser des nanocristaux de silicium recouverts d'une couche de nitrure de silicium.

Le procédé selon l'invention est un procédé de réalisation d'une structure comprenant des nanocristaux de matériau semi-conducteur sur un substrat de matériau diélectrique par dépôt chimique en phase vapeur (CVD), les nanocristaux étant recouverts d'une couche de nitrure de matériau semi-conducteur, ledit procédé comprenant :
- une étape de germination par formation sur le substrat de matériau diélectrique de germes stables sous forme d'îlots, par dépôt CVD à partir d'un premier gaz précurseur des germes choisi pour que le matériau diélectrique accepte la formation desdits germes,
- une étape de croissance par formation de nanocristaux de matériau semi-conducteur à partir des germes stables, par dépôt CVD à partir d'un second gaz précurseur choisi pour engendrer un dépôt sélectif dudit matériau semi-conducteur des nanocristaux uniquement sur lesdits germes,
- une étape de passivation par formation d'une couche de nitrure de matériau semi-conducteur sur les nanocristaux de matériau semi-conducteur,
ledit procédé étant caractérisé en ce que l'étape de passivation est réalisée par dépôt CVD sélectif et stoechiométrique de nitrure de matériau semi-conducteur uniquement sur les nanocristaux de matériau semi-conducteur à partir d'un mélange du second gaz précurseur avec un troisième gaz précurseur choisi de manière à ce que le mélange soit apte à engendrer un dépôt sélectif et stoechiométrique du nitrure de matériau semi-conducteur uniquement sur lesdits nanocristaux de matériau semi-conducteur, les étapes de formation des germes, de formation des nanocristaux et de passivation étant réalisées au sein d'une seule et même enceinte.
Le dépôt chimique en phase vapeur (CVD) peut en particulier être réalisé à basses pressions, par exemple par LPCVD (pour « Low Pression CVD » en anglais) avec une pression inférieure à 2 Torrs ou par RPCVD (pour « Reduce Pression CVD » en anglais) avec une pression inférieure à 20 Torrs et l'ajout d'un gaz porteur, par exemple H₂.

Il est important que la couche de nitrure soit stoechiométrique afin qu'elle puisse assurer une bonne résistance aux procédés ultérieurs oxydants.

Il est à noter qu'étant donné que toutes les étapes se font au sein d'une même enceinte, on élimine les risques de contamination des éléments constitutifs du dispositif.

Avantageusement, le premier gaz précurseur, le second gaz précurseur et le mélange du second gaz précurseur avec le troisième gaz précurseur sont envoyés dans l'enceinte selon un flux continu.

Avantageusement, le procédé selon l'invention comprend en outre une étape de préparation de la surface du substrat de matériau diélectrique, avant l'étape de germination, par attaque chimique de ladite surface à l'aide de HF, HF-RCA ou RCA, de manière à former des groupes -OH en surface dudit substrat de matériau diélectrique et favoriser la formation des germes. Par exemple, le silane (et les dérivés du silane) se décompose sur un site OH ; le nettoyage de la surface du substrat par HF, HF-RCA ou RCA permet donc d'augmenter le nombre de sites OH présents en surface du substrat sur lesquels le silane pourra se décomposer.

Avantageusement, le matériau diélectrique formant le substrat est un oxyde thermique.

Le nettoyage RCA est le nettoyage industriel standard utilisé pour enlever la contamination de surface. Il se compose de deux bains chimiques SC1 et SC2 (pour « Standard clean 1 » et « Standard clean 2 »). On peut faire précéder le nettoyage RCA d'un nettoyage HF (nettoyage HF-RCA), c'est-à-dire d'un bain d'acide fluorhydrique qui réagit avec ou enlève la silice.

Avantageusement, le substrat de matériau diélectrique est choisi parmi le groupe composé d'un oxyde de silicium thermique, un oxyde de silicium comprenant une forte densité de groupes Si-OH à sa surface ou un matériau dit « high-K » (c'est-à-dire un diélectrique à permittivité élevée ayant un K supérieur à 6) tel que HfO₂, Al₂O₃, un aluminate d'hafnium ou un silicate d'hafnium.

Avantageusement, le matériau semi-conducteur des nanocristaux et/ou de la couche de nitrure est choisi parmi du silicium, du germanium ou un composé germanium-silicium. Ainsi, on peut former par exemple des nanocristaux de silicium recouverts de nitrure de silicium.

Selon une première variante, les nanocristaux sont en silicium et la couche recouvrant lesdits nanocristaux est en nitrure de silicium ou en nitrure de germanium.

Selon une seconde variante, les nanocristaux sont en germanium et la couche recouvrant lesdits nanocristaux est en nitrure de silicium.

Avantageusement, l'étape de germination est réalisée à une température de dépôt et pendant un temps d'exposition au premier gaz précurseur choisis de manière à obtenir une densité de germes supérieure ou égale à 10¹⁰ germes par cm² et des germes ayant une taille inférieure ou égale à 10 nm.

Avantageusement, l'étape de croissance des nanocristaux est réalisée à une température de dépôt, pendant un temps d'exposition au second gaz précurseur et à une pression partielle du second gaz précurseur choisis en fonction de la taille des nanocristaux voulue.

Avantageusement, le premier gaz précurseur (11) est choisi parmi le silane, le disilane ou le trisilane.

Avantageusement, le second gaz précurseur est choisi parmi le germane (GeH₄), le dichlorosilane (DCS ou SiH₂Cl₂) ou un mélange de ces deux gaz.

Selon un mode de réalisation particulier, le premier et le second gaz précurseurs étant respectivement du silane et du dichlorosilane, la température et le temps de dépôt de l'étape de croissance sont supérieurs à la température et au temps de dépôt de l'étape de germination.

Avantageusement, le troisième gaz précurseur (utilisé en mélange avec le second gaz précurseur) est de l'ammoniac (NH₃).

Avantageusement, le substrat de matériau diélectrique étant un oxyde de silicium thermique, l'étape de passivation est réalisée pendant un temps de dépôt du gaz, formé du mélange du second gaz précurseur et du troisième gaz précurseur, inférieur à 8 minutes.

L'invention concerne également, d'une part, une cellule mémoire possédant une grille flottante, caractérisée en ce que la grille flottante est constituée de nano-structures obtenues selon le procédé de l'invention et d'autre part, une mémoire Flash comprenant au moins une telle cellule mémoire.

### BRÈVE DESCRIPTION DES DESSINS

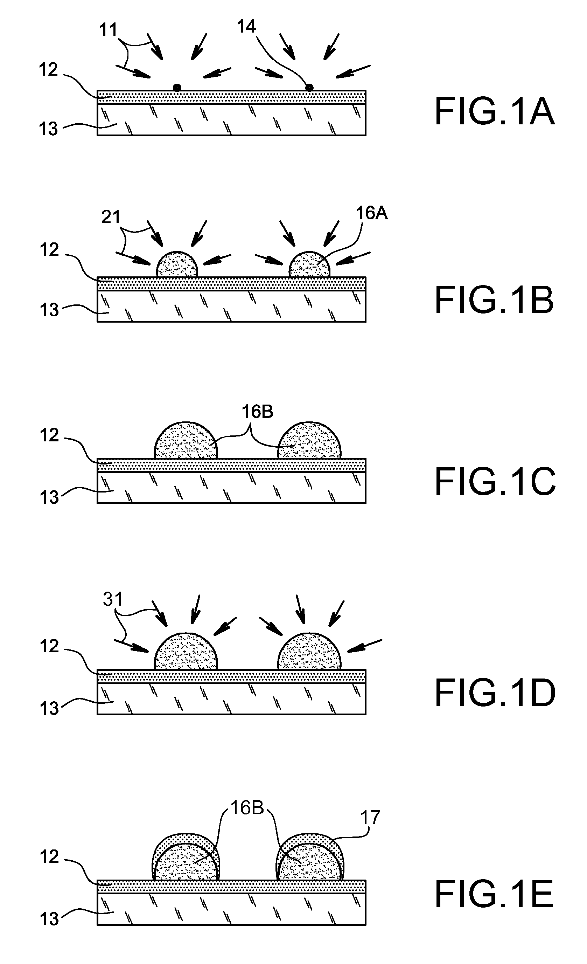

L'invention sera mieux comprise et d'autres avantages et particularités apparaîtront à la lecture de la description qui va suivre, donnée à titre d'exemple non limitatif, accompagnée des dessins annexés parmi lesquels les figures 1A à 1E représentent les étapes du procédé selon l'invention.

### EXPOSÉ DÉTAILLÉ D'UN MODE DE RÉALISATION PARTICULIER

Le procédé selon l'invention comporte trois étapes :
- une étape de germination,
- une étape de croissance de nanocristaux sur les germes formés à l'étape de germination,
- une étape de passivation des nanocristaux.

Le but de l'étape de germination est de créer sur le diélectrique des « germes » autour desquels vont croître les nanocristaux. Etant donné que le dépôt se fait sur un diélectrique, on doit utiliser un précurseur capable de déposer sur ce diélectrique. Par exemple, pour un diélectrique en oxyde de silicium, on peut utiliser du silane SiH₄.

De manière à limiter au maximum la dispersion en taille des nanocristaux et obtenir une densité de nanocristaux supérieure à 10¹² germes par centimètre carré, on choisit un temps de dépôt suffisamment court pour ne pas obtenir une taille de germes supérieure à 1 nm et suffisant pour obtenir la densité recherchée (en sachant que la densité de germes sera équivalente à la densité de nanocristaux, étant donné que les nanocristaux croissent sur les germes). Par exemple, on peut choisir un temps de dépôt allant de quelques secondes à quelques minutes, par exemple de 10 secondes à 10 minutes.

On choisit également une température de dépôt suffisante pour que le gaz précurseur puisse se dissocier. Si on veut obtenir des germes cristallins, la température de dépôt devra être suffisante pour obtenir un dépôt cristallin et non amorphe. Il faut noter que le temps et la température de dépôt sont difficilement dissociables et le choix de l'un influe sur le choix de l'autre. La température peut être comprisse entre 550 et 650°C, par exemple 600°C.

Enfin, on choisit une pression partielle du gaz précurseur des germes relativement élevée, c'est-à-dire une pression comprise entre 10 mTorr et 1 Torr, de manière à obtenir une forte densité de germes. La pression partielle peut par exemple être de 60 mTorr.

On notera que lors de l'étape de germination, deux phénomènes concurrents entrent en jeu. D'une part, il y a la création des germes, et d'autre part, la croissance de nanocristaux autour des germes déjà existants. Le choix des paramètres de germination tels que la température et le temps de dépôt, ainsi que la pression partielle du gaz précurseur se fera en essayant de limiter le deuxième phénomène. Ainsi, le temps de dépôt sera choisi suffisamment court pour limiter le deuxième phénomène de croissance autour des germes.

Pour limiter le deuxième phénomène, on peut également préparer la surface du diélectrique afin de favoriser largement la création de germes par rapport à la croissance autour de germes déjà existants.

L'étape de croissance permet de faire croître les nanocristaux à partir des germes jusqu'à la taille voulue, sans créer de nouveaux nanocristaux. Le gaz précurseur des nanocristaux est choisi de manière à ce qu'il se dissocie sur les germes existants, mais pas sur le diélectrique. La taille des nanocristaux est limitée par ce qu'on appelle la coalescence (le point où les îlots commencent à se rejoindre pour former une couche continue) et la densité des nanocristaux est par conséquent fixée lors de l'étape précédente de germination. On choisit donc un gaz précurseur sélectif et une vitesse de croissance maîtrisée pour obtenir la taille de nanocristaux voulue. Par exemple, on peut choisir comme gaz précurseur sélectif le dichlorosilane (DCS), le germane GeH₄ ou un mélange des deux. La température et le temps de croissance sont choisis de manière à obtenir la taille des nanocristaux voulue.

La pression partielle du ou des gaz précurseur(s) des nanocristaux se choisit également en fonction de la taille des nanocristaux et donc de la vitesse de croissance voulue. Par exemple, dans le cas de nanocristaux de silicium, on choisira comme gaz précurseur du DCS, une température en générale supérieure à celle de l'étape de germination (entre 600 et 850°C par exemple), un temps de dépôt également supérieur à celui de l'étape de germination (quelques minutes) et une pression partielle inférieure ou égale a celle de l'étape de germination.

L'étape de passivation consiste à déposer une couche protectrice sur les nanocristaux, afin que ces derniers ne s'oxydent pas. Comme on l'a vu précédemment, le matériau idéal pour constituer une barrière efficace à l'oxydation est le nitrure de silicium. De plus, on veut que la couche de passivation ne soit située que sur les nanocristaux. Il faut donc que le dépôt soit sélectif, afin que le dépôt ait lieu uniquement sur les nanocristaux, mais pas sur le diélectrique. On doit donc choisir un ou des gaz précurseurs sélectif(s). Pour déposer du nitrure de silicium, le gaz précurseur sélectif peut être du DCS auquel on ajoute de l'ammoniac NH₃ pour constituer un mélange. Pour déposer du nitrure de germanium, le gaz précurseur sélectif peut être du GeH₄ ou du GeCl₄ auquel on ajoute de l'ammoniac NH₃ pour constituer un mélange.

La couche de nitrure de silicium doit recouvrir les nanocristaux et être capable de jouer le rôle de barrière à l'oxydation, mais doit être également suffisamment fine, ou avoir duré suffisamment peu de temps, pour que la croissance du nitrure de silicium n'ait pas lieu sur le diélectrique.

Un nitrure épais constitue une barrière efficace à l'oxydation car les espèces oxydantes sont bloquées par le nitrure et seule la surface de la couche de nitrure s'oxyde. Mais en dessous d'une certaine épaisseur (appelée épaisseur critique), les espèces oxydantes traversent la couche de nitrure et oxydent le nanocristal présent sous le nitrure. Cette épaisseur critique est de l'ordre de quelques nanomètres et dépend de plusieurs facteurs, en particulier de la température et de la sélectivité du dépôt nitrure.

Pour un nitrure LPCVD déposé à 600°C, l'épaisseur critique est de 3 nm et est de 5 nm pour un nitrure à 750°C (voir document **[5]**). Ces résultats s'expliquent par la présence d'une sous-couche non stoechiométrique (Si-rich), dite couche de transition, lorsque le nitrure est déposé sur un oxyde ou du silicium ayant en surface un oxyde natif. En effet, c'est cette couche de transition non stoechiométrique qui présente une faible résistance à l'oxydation et l'épaisseur de cette sous-couche dépend de la température de dépôt.

La sélectivité du dépôt nitrure est fréquemment désignée dans la littérature par « retard à la nucléation » ou « période d'incubation ». Cette période d'incubation est maximum lorsqu'on dépose du nitrure sur un oxyde thermique, elle reste significative sur du silicium avec un oxyde natif en surface, elle décroît si on dépose le nitrure sur du nitrure (avec une surface oxydée à l'air) et elle décroît encore si on dépose sur une surface de silicium ou de nitrure désoxydée (en général obtenue par un nettoyage HF). Pour des conditions de dépôt nitrure LPCVD standard, on trouve dans la littérature un retard d'environ 8 minutes sur un oxyde thermique, puis environ 5 minutes sur du silicium avec oxyde natif en surface, et enfin, sur du silicium avec une surface désoxydée ou du silicium à nu, ce retard est quasiment réduit à zéro. Ceci s'explique par les différents états de surface, plus ou moins favorable à la nucléation. Ainsi, un oxyde thermique présente des liaisons siloxanes -Si-O-Si- en surface, ce qui représente le cas le plus défavorable pour la nucléation, le cas intermédiaire correspond à une majorité de liaisons silanol Si-OH pour l'oxyde natif et le cas le plus favorable est la liaison Si-H sur du silicium à nu. On obtient donc un dépôt nitrure sélectif si l'on se place dans ces conditions, le cas le plus favorable étant une surface avec du silicium à nu contre un oxyde thermique, avec une durée de dépôt inférieure à 8 minutes.

Par ailleurs, nous avons vu qu'un nitrure déposé sur oxyde ou silicium avec oxyde natif en surface présentait une sous couche non stoechiométrique, dite couche de transition, allant de 3 à 5 nm selon la température de dépôt. Dans le cas d'un dépôt nitrure réalisé sur du silicium désoxydé, cette sous-couche de transition disparaît (ou a tendance à disparaître) pour laisser à la place une couche directement stoechiométrique.

Comme nous l'avons vu plus haut (voir document **[5]**), un nitrure stoechiométrique présente une très bonne résistance à l'oxydation et un nitrure mince de 2 nm déposé sur du silicium désoxydé constitue une barrière à l'oxydation suffisamment efficace pour résister à une oxydation à 850°C, et ce, que le film de nitrure soit déposé à 650°C ou à 750°C.

Au vu de ce qui précède, on voit qu'un nitrure de silicium de 2 nm d'épaisseur peut être suffisamment efficace pour protéger des nanocristaux de silicium si le dépôt est stoechiométrique, c'est-à-dire réalisé sur du silicium à nu. Il est donc important que le dépôt de nitrure soit un dépôt stoechiométrique. Concernant la sélectivité du dépôt, on se place dans les conditions les plus favorables, c'est-à-dire silicium à nu contre oxyde thermique et à un temps de dépôt inférieur à 8 minutes. Si ces conditions sont respectées, les conditions de dépôt nitrure sont celles d'un dépôt nitrure standard, c'est-à-dire que la température peut être la même que celle de l'étape de croissance des nanocristaux (dans la gamme des 600-850°C par exemple), les pressions partielles et le ratio DCS/NH₃ sont ceux d'un dépôt nitrure LPCVD standard. Seuls le temps de dépôt, qui doit être impérativement inférieur à 8 minutes pour avoir un dépôt sélectif, et la pression totale, qui permet de contrôler la vitesse de croissance donc par conséquent l'épaisseur de nitrure déposé (de l'ordre de 2-3 nm par exemple), doivent être ajustés.

A titre d'exemple, nous allons décrire le mode de réalisation de nanocristaux de silicium sur un substrat diélectrique en oxyde thermique, les nanocristaux étant enrobés dans du nitrure de silicium.

Sur un substrat de silicium, on forme une couche d'oxyde thermique. Le substrat d'oxyde thermique est placé dans l'enceinte d'un bâti technologique. L'enceinte est chauffée progressivement jusqu'à la température de germination, selon une rampe de température sous une atmosphère de gaz inerte (azote N₂ ou hydrogène H₂).

De préférence, le substrat subit un nettoyage de surface avant de subir la germination de manière à favoriser un état de surface particulier. Par exemple, le substrat d'oxyde thermique peut subir un nettoyage chimique de surface à l'aide d'une solution de HF de manière à favoriser les terminaisons silanol (-OH), qui constituent des sites de nucléation privilégiés pour les nanocristaux de silicium.

Au cours de l'étape de germination, on envoie sur le substrat 13 recouvert d'une couche de diélectrique 12 un gaz 11, précurseur, qui va permettre la formation de germes 14 sur le diélectrique 12 (figure 1A). Les germes 14 en silicium peuvent être formés à une température comprise entre 550°C et 700°C et à une pression partielle du silane inférieure à environ 133 Pa (1 Torr). L'intervalle de température de dépôt est choisi de manière à ce que la température soit suffisamment élevée pour que le précurseur puisse se dissocier et engendrer la formation d'un germe cristallin, et également la plus basse possible afin de limiter la vitesse de croissance des germes.

Ici, on choisit d'opérer à une température de germination de 600°C et une pression partielle de 60 mT. On augmente donc la température jusqu'à atteindre 600°C, puis on commence l'étape de germination en injectant un gaz de silane de 60 cc dans l'enceinte, pendant 30s, à une pression de 60 mT : on dépose ainsi des germes de silicium sur le substrat d'oxyde thermique.

L'étape de germination est suivie d'une étape de croissance sélective de nanocristaux de silicium sur les germes. On envoie un gaz précurseur 21 des nano-structures 16A que l'on veut obtenir, c'est-à-dire des nano-structures de silicium, et celles ci vont croître sélectivement sur les germes 14 formés pendant l'étape de germination (figure 1B). Les nanocristaux vont croître jusqu'à atteindre une taille déterminée à la fin de l'étape de croissance, la taille des nanocristaux étant déterminée par le choix de la température et le temps de dépôt de l'étape de croissance, ainsi que par la pression partielle du gaz précurseur utilisé : on obtient ainsi des nanocristaux de taille homogène 16 B (figure 1C). Dans notre exemple de réalisation, on injecte 60 cc d'un gaz de dichlorosilane DCS à une pression de 60 mT, en augmentant progressivement la température de 600 à 700°C pendant 10 minutes.

Avec un procédé RPCVD, la montée en température est de l'ordre de quelques secondes pour passer de 600°C à 700°C. Il faut alors ajouter une étape spécifique de croissance des nanocristaux avec du dichlorosilane pendant quelques minutes à 700°C.

Ensuite, on effectue l'encapsulation des nanocristaux de silicium 16B en injectant un mélange de gaz précurseurs 31 composé de 0,2 slm de NH₃ et de 40 cc de DCS, à une pression de 220 mT, à une température de 700°C et pendant une durée de 5 minutes (figure 1D). On obtient ainsi un dépôt de nitrure sélectif et stoechiométrique 17 sur les nanocristaux de silicium 16B (figure 1E) .

Enfin, on baisse la température dans l'enceinte jusqu'à température ambiante, selon une rampe de température sous gaz inerte d'azote.

On obtient ainsi un dispositif constitué d'un substrat 13 comprenant une couche d'oxyde thermique 12 et des nanocristaux de silicium 16B enrobés de nitrure de silicium 17. Les nanocristaux ont un coeur silicium qui mesure entre 6 et 8 nm. La couche de nitrure de silicium a une épaisseur d'approximativement 2 nm. La densité de nanocristaux est d'environ 10¹² nanocristaux par cm².

Avantageusement, les gaz utilisés au cours du procédé de réalisation des nanocristaux de silicium sur le substrat diélectrique en oxyde thermique sont envoyés dans l'enceinte selon un flux continu : il y a donc ainsi un flux continu de gaz successifs différents au sein d'une même enceinte au cours du procédé.

La réalisation de nanocristaux sur un diélectrique et protégés par une couche de nitrure peut être utile pour fabriquer des mémoires flash.

Pour cela, on réalise comme expliqué précédemment des nanocristaux de silicium sur un diélectrique en oxyde de silicium et on recouvre les nanocristaux de nitrure de silicium. Les autres étapes de formation des mémoires flash (notamment la formation de l'oxyde tunnel et de la grille de contrôle) sont semblables aux étapes conventionnelles de formation.

### BIBLIOGRAPHIE

**[1]** B. De Salvo et al, "How far will Silicon Nanocrystals push the scaling limits of NVMs technologies?", Technical Digest of IEEE International Electron Devices Meeting 2003, pp. 597-600, Washington, DC, december 7-10, 2003.
**[2]** F. Mazen et al, "A two step process for the growth of silicon nano-crystals", Applied Surface Science 214, p359-363, march 2003.
**[3]** K. C. Scheer et al., "Thermal oxidation of silicon nanocrystals in O2 and NO ambient", Journal of Applied Physics, vol. 93, n° 9, 1 May 2003.
**[4]** S Huang et al., "Toward Long-Term Retention-Time Single-Electron-Memory Devices Based on Nitrided Nanocrystalline Silicon Dots", IEEE Transactions on Nanotechnology, vol. 3, n° 1, march 2004.
**[5]** M Yoshimaru et al., "Effets of Deposition Temperature on the Oxidation Resistance and Electrical Characteristics of Silicon Nitride", IEEE Transactions on Electron Devices, vol 41, n° 10, October 1994.

## Revendications

1. Procédé de réalisation d'une structure comprenant des nanocristaux de matériau semi-conducteur sur un substrat de matériau diélectrique par dépôt chimique en phase vapeur (CVD), les nanocristaux étant recouverts d'une couche de nitrure de matériau semi-conducteur, ledit procédé comprenant :
- une étape de germination par formation sur le substrat de matériau diélectrique (12) de germes stables (14) sous forme d'îlots, par dépôt CVD à partir d'un premier gaz précurseur (11) des germes choisi pour que le matériau diélectrique (12) accepte la formation desdits germes (14),
- une étape de croissance par formation de nanocristaux (16A, 16B) de matériau semi-conducteur à partir des germes stables (14), par dépôt CVD à partir d'un second gaz précurseur (21) choisi pour engendrer un dépôt sélectif dudit matériau semi-conducteur des nanocristaux uniquement sur lesdits germes (14),
- une étape de passivation par formation d'une couche de nitrure de matériau semi-conducteur sur les nanocristaux de matériau semi-conducteur,
ledit procédé étant **caractérisé en ce que** l'étape de passivation est réalisée par dépôt CVD sélectif et stoechiométrique de nitrure de matériau semi-conducteur (17) uniquement sur les nanocristaux de matériau semi-conducteur à partir d'un mélange (31) du second gaz précurseur avec un troisième gaz précurseur choisi de manière à ce que le mélange (31) soit apte à engendrer un dépôt sélectif et stoechiométrique du nitrure de matériau semi-conducteur uniquement sur lesdits nanocristaux de matériau semi-conducteur, les étapes de formation des germes, de formation des nanocristaux et de passivation étant réalisées au sein d'une seule et même enceinte.

2. Procédé selon la revendication 1, dans lequel le premier gaz précurseur, le second gaz précurseur et le mélange du second gaz précurseur avec le troisième gaz précurseur sont envoyés dans l'enceinte selon un flux continu.

3. Procédé selon la revendication 1 ou 2, comprenant en outre une étape de préparation de la surface du substrat de matériau diélectrique (12), avant l'étape de germination, par attaque chimique de ladite surface à l'aide de HF, HF-RCA ou RCA, de manière à former des groupes -OH en surface dudit substrat de matériau diélectrique (12) et favoriser la formation des germes (14).

4. Procédé selon l'une quelconque des revendications 1 à 3, dans lequel le substrat de matériau diélectrique (12) est choisi parmi le groupe composé d'un oxyde de silicium thermique, un oxyde de silicium thermique comprenant une forte densité de groupes Si-OH à sa surface ou un matériau dit « high-K » tel que HfO₂, Al₂O₃, un aluminate d'hafnium ou un silicate d'hafnium.

5. Procédé selon l'une quelconque des revendications 1 à 4, dans lequel le matériau semi-conducteur des nanocristaux et/ou de la couche de nitrure est choisi parmi du silicium, du germanium et du silicium-germanium SiGe.

6. Procédé selon la revendication 5, dans lequel les nanocristaux étant en silicium, la couche recouvrant lesdits nanocristaux est en nitrure de silicium ou en nitrure de germanium.

7. Procédé selon la revendication 5, dans lequel les nanocristaux étant en germanium, la couche recouvrant lesdits nanocristaux est en nitrure de silicium.

8. Procédé selon l'une quelconque des revendications 1 à 7, dans lequel l'étape de germination est réalisée à une température de dépôt et pendant un temps d'exposition au premier gaz précurseur choisis de manière à obtenir une densité de germes supérieure ou égale à 10¹⁰ germes par cm² et des germes ayant une taille inférieure ou égale à 10 nm.

9. Procédé selon l'une quelconque des revendications 1 à 8, dans lequel l'étape de croissance des nanocristaux (16A) est réalisée à une température de dépôt, pendant un temps d'exposition au second gaz précurseur et à une pression partielle du second gaz précurseur choisis en fonction de la taille des nanocristaux (16B) voulue.

10. Procédé selon l'une quelconque des revendications 1 à 9, dans lequel le premier gaz précurseur (11) est choisi parmi le silane, le disilane ou le trisilane.

11. Procédé selon l'une quelconque des revendications 1 à 10, dans lequel le second gaz précurseur (21) est choisi parmi le germane (GeH₄), le dichlorosilane (SiH₂Cl₂) ou un mélange de ces deux gaz.

12. Procédé selon les revendications 10 et 11 prises ensemble, dans lequel le premier et le second gaz précurseurs étant respectivement du silane et du dichlorosilane, la température et le temps de dépôt de l'étape de croissance sont supérieurs à la température et au temps de dépôt de l'étape de germination.

13. Procédé selon la revendication 11 ou 12, dans lequel le troisième gaz précurseur est de l' ammoniac (NH₃).

14. Procédé selon l'une quelconque des revendications 1 à 13, dans lequel le substrat de matériau diélectrique (12) étant un oxyde de silicium thermique, l'étape de passivation est réalisée pendant un temps de dépôt du gaz, formé du mélange du second gaz précurseur et du troisième gaz précurseur, inférieur à 8 minutes.

15. Cellule mémoire possédant une grille flottante, **caractérisée en ce que** la grille flottante est constituée de nano-structures obtenues selon l'une quelconque des revendications 1 à 14.

16. Mémoire Flash comprenant au moins une cellule mémoire telle que revendiquée dans la revendication 15.
